# EUROPÄISCHE PATENTSCHRIFT

(11) **EP 2 457 108 B1**
(45) Veröffentlichungstag und Bekanntmachung des Hinweises auf die Patenterteilung: **28.09.2016**
(21) Anmeldenummer: 10724311.5
(22) Anmeldetag: 10.06.2010
(51) Int. Cl.: F02N 11/08, G01R 31/36

(54) **VERFAHREN ZUM BETREIBEN EINES FAHRZEUGS UND STEUEREINRICHTUNG FÜR EIN FAHRZEUG**
METHOD FOR OPERATING A VEHICLE AND CONTROL DEVICE FOR A VEHICLE
PROCÉDÉ PERMETTANT DE FAIRE FONCTIONNER UN VÉHICULE ET DISPOSITIF DE COMMANDE POUR UN VÉHICULE

(30) Priorität: 21.07.2009 DE 102009034004
(43) Veröffentlichungstag der Anmeldung: 30.05.2012
(73) Patentinhaber: Audi AG, 85045 Ingolstadt (DE)
(72) Erfinder: HOFMAN, Reinhard, 85110 Kipfenberg (DE); THELE, Marc, 85049 Ingolstadt (DE); MERKEL, Rolf, 85051 Ingolstadt (DE)
(74) Vertreter: Mader, Wilfried
(86) Internationale Anmeldenummer: PCT/EP2010/003487
(87) Internationale Veröffentlichungsnummer: WO 2011/009511

(56) Entgegenhaltungen:
- EP-A2- 0 916 959
- EP-A2- 1 207 297
- DE-A1- 10 107 583
- DE-A1- 19 831 723
- US-B1- 7 218 118

## Beschreibung

Die Erfindung betrifft ein Verfahren zum Betreiben eines Fahrzeugs mit einer Fahrzeugbatterie, bei welchem beim Starten eines Antriebesmotors des Fahrzeugs der Wert eines Spannungseinbruchs an der Fahrzeugbatterie erfasst wird, und bei welchem aus einer Mehrzahl an derartigen Werten des Spannungseinbruchs ein Mittelwert gebildet wird. Des Weiteren betrifft die Erfindung eine Steuereinrichtung zum Durchführen eines solchen Verfahrens.

Die DE 197 50 309 A1 beschreibt ein Verfahren zur Bestimmung der Startfähigkeit einer Fahrzeugbatterie. Hierbei sind in einem Kennlinienfeld Mittelwerte von Spannungseinbrüchen an der Fahrzeugbatterie beim Startvorgang mit den zugehörigen Batterietemperaturen und Motortemperaturen abgelegt. Bei einem Start des Motors wird der Spannungseinbruch der Fahrzeugbatterie bei der aktuell vorliegenden Batterietemperatur und der aktuell vorliegenden Motortemperatur gemessen. Weicht der aktuelle Spannungseinbruch bei gleicher Batterietemperatur und Motortemperatur von dem in dem Kennfeld abgelegten Mittelwert um mehr als eine vorgegebene Größe ab, so wird dies angezeigt. Es kann so auf eine stark fortgeschrittene Alterung der Fahrzeugbatterie geschlossen werden.

Die Aussagekraft dieses aus dem Stand der Technik bekannten Verfahrens ist jedoch beschränkt.

Die EP 1 207 297 A2 beschreibt ein Verfahren zur Ermittlung der Startfähigkeit einer Starterbatterie eines Verbrennungsmotors. Zur Bestimmung der Startfähigkeit wird dabei der mittlere Spannungsabfall in der Starterbatterie während des Starts genutzt. Dabei kann ein Kennfeld für den mittleren Spannungsabfall ermittelt werden, indem für jeweils einen Temperaturwert der Batterie der mittlere Spannungsabfall für verschiedene Werte des Ladezustands soc der Batterie ermittelt wird. Die entsprechenden Kurven des Kennfeldes ergeben sich dann durch Inter- bzw. Extrapolation dieser ermittelten Werte und können abgespeichert werden. So kann durch Ermitteln der Batterietemperatur und des Ladezustands vor einem Startvorgang der mittlere Spannungsabfall anhand des abgespeicherten Kennfeldes ermittelt werden und somit für den Startvorgang vorhergesagt werden, ob eine Mindestspannung zur Erreichung der Startdrehzahl bereitstellbar ist.

Die EP 0 916 959 A2 beschreibt ein Verfahren zur Bestimmung der Startfähigkeit der Starterbatterie eines Kraftfahrzeugs. Dabei wird bei jedem Start des Verbrennungsmotors der Mittelwert des Spannungseinbruchs gemessen und mit den Spannungswerten eines Kennlinienfeldes verglichen, welches aus gemessenen Spannungseinbrüchen und zugehörigen Batterie- und Motortemperaturen besteht. Die Spannungswerte des Kennlinienfeldes wurden dabei in einer Batterieneuphase bestimmt und abgespeichert. Durch die Abweichung des mittleren Spannungseinbruchs beim Start des Verbrennungsmotors vom Vergleichswert des Kennlinienfeldes lässt sich eine Aussage über die Alterung der Batterie treffen.

Die DE 198 31 723 A1 beschreibt ein Verfahren zur Ladezustandserkennung einer Fahrzeugbatterie, bei dem während des Betriebs des Starters der Spannungsabfall der Batteriespannung erfasst wird und einem Ladezustandswert zugeordnet wird.

Die US 7 218 118 B1 beschreibt ein Verfahren zum Überwachen des Zustands einer Batterie eines Schiffs. Dabei wird ein charakteristischer Spannungswert der Batterie beim Starten des Motors erfasst. Insbesondere kann dabei als charakteristischer Spannungswert der Wert des Spannungsminimums bei einer Aktivierung des Starters erfasst werden.

Die DE 101 07 583 A1 beschreibt ein Verfahren zur Bestimmung der Leistungsfähigkeit einer Speicherbatterie, bei dem der zeitliche Verlauf des Spannungsabfalls bei Hochstrombelastung ausgewertet wird, indem aus der Spannungsantwort ein Spannungswert, bevorzugt das Minimum der Spannungsantwort, ausgewählt wird und aus diesem Wert sowie aus der Batterietemperatur und dem Ladezustand der Batterie ein Zustandswert gebildet wird, der mit einem Vorgabewert verglichen wird.

Aufgabe der vorliegenden Erfindung ist es, bei einem Verfahren der eingangs genannten Art eine weitere Möglichkeit der Verwendung des Mittelwerts anzugeben.

Diese Aufgabe wird durch ein Verfahren mit den Merkmalen des Patentanspruchs 1 und durch eine Steuereinrichtung mit den Merkmalen des Patentanspruchs 5 gelöst. Vorteilhafte Ausgestaltungen mit zweckmäßigen Weiterbildungen der Erfindung sind in den jeweils abhängigen Ansprüchen angegeben.

Bei dem erfindungsgemäßen Verfahren zum Betreiben eines eine Fahrzeugbatterie aufweisenden Fahrzeugs wird beim Starten eines Antriebsmotors des Fahrzeugs der Wert eines Spannungseinbruchs an der Fahrzeugbatterie erfasst. Aus einer Mehrzahl an derartigen Werten des Spannungseinbruchs wird ein Mittelwert gebildet, wobei jeweils ein Wert der Mehrzahl an derartigen Werten bei jeweils einem Starten des Antriebsmotors erfasst wird. Der Mittelwert wird dazu herangezogen, eine beim nächsten Starten des Antriebsmotors zu erwartende Spannung an der Fahrzeugbatterie vorherzusagen. Dabei wird der Mittelwert auf einen Bezugswert einer Batterietemperatur der Fahrzeugbatterie normiert, wobei sich die zu erwartende Spannung aus einem Spannungsniveau an einem Ende einer Stopp-Phase eines Start-Stopp-Betriebs des Fahrzeugs vor dem nächsten Starten des Antriebsmotors abzüglich des auf eine aktuelle Batterietemperatur der Fahrzeugbatterie entnormierten Mittelwerts der Werte des Spannungseinbruchs ergibt. Das Vorhersagen der zu erwartenden Spannung der Fahrzeugbatterie ermöglicht so einen Start-Stopp-Betrieb des Fahrzeugs, bei welchem eine unerwünschte Unterspannung an Bordnetzverbrauchern vermeidbar ist. Somit ist eine den Komfort erhöhende Möglichkeit der Verwendung des Mittelwerts angegeben.

Der Erfindung liegt die Erkenntnis zugrunde, dass ein unerwünscht hoher Spannungseinbruch an der Fahrzeugbatterie beim nächsten Starten des Antriebsmotors zu einer Unterspannung an einem Bordnetzverbraucher, beispielsweise einem Steuergerät, führen könnte, welche ein Zurücksetzen (Reset) des Bordnetzverbrauchers zur Folge haben könnte. Der Spannungswert, bei welchem beispielsweise das Steuergerät einen solchen Reset durchführt, ist von der Elektronik des Steuergeräts, von Alterungseffekten der Elektronik und von Umgebungsbedingungen, beispielsweise der Temperatur, abhängig. Kann nun die beim nächsten Starten des Antriebsmotors zu erwartende Spannung an der Fahrzeugbatterie vorhergesagt werden, so ist es möglich festzustellen, ob die zur erwartende Spannung so groß ist, dass bevorzugt an keinem der Bordnetzverbraucher aufgrund einer Unterspannung ein Reset erfolgt. Es kann also während der Antriebsmotor läuft entschieden werden, ob ein Stoppen des Antriebsmotors möglich ist.

Der Erfindung liegt des Weiteren die Erkenntnis zugrunde, dass der Spannungseinbruch an der Fahrzeugbatterie beim Starten des Antriebsmotors in weiten Bereichen unabhängig vom Ladezustand der Fahrzeugbatterie ist. Vielmehr sind den Spannungseinbruch maßgeblich beeinflussende Parameter die Größe der Fahrzeugbatterie, die Ausbildung der Verkabelung zwischen der Fahrzeugbatterie und dem Starter und die Auslegung des Starters selber.

Der Spannungseinbruch hängt also hauptsächlich von statischen, fahrzeugspezifischen Parametern ab, welche zudem allenfalls einer sehr langsam vor sich gehenden, etwa durch Alterungseffekte bewirkten, Änderung unterworfen sind. Dies ermöglicht das adaptive Anlernen des fahrzeugspezifischen Spannungseinbruchs durch das Bilden des Mittelwerts.

In einer vorteilhaften Ausgestaltung der Erfindung wird ein dem nächsten Starten vorausgehendes Stoppen des Antriebsmotors unterbunden, wenn die zu erwartende Spannung an der Fahrzeugbatterie geringer ist als eine vorgegebene Mindestspannung. Vorzugsweise ist die Mindestspannung so gewählt, dass beim nächsten Starten des Antriebsmotors und dem damit einhergehenden Spannungseinbruch an keinem der Bordnetzverbraucher eine zu einem Reset des Bordnetzverbrauchers führende Unterspannung anliegt. So ist sicher vermeidbar, dass ein für einen Fahrzeugnutzer wahrnehmbarer Reset eines Bordnetzverbrauchers, insbesondere eines Steuergeräts, vorkommt.

In einer weiteren Ausgestaltung der Erfindung wird aus der Summe des Mittelwerts und der vorgegebenen Mindestspannung ein Grenzwert der Spannung bestimmt, bei dessen Überschreiten ein Stoppen des Antriebsmotors erlaubt wird. Dadurch wird das Erlauben des Stoppens des Antriebsmotors davon abhängig gemacht, ob trotz des beim nächsten Starten sich einstellenden Spannungseinbruchs an der Fahrzeugbatterie die vorgegebene Mindestspannung für die Bordnetzverbraucher zur Verfügung steht. So sind für das vorübergehende Außer-Betrieb-Nehmen des Antriebsmotors vorteilhafte Randbedingungen definiert.

Der Grenzwert der Spannung, bei dessen Überschreitung ein Stoppen des Antriebsmotors erlaubt wird, kann insbesondere dazu herangezogen werden, einen korrespondierenden Ladezustand der Fahrzeugbatterie zu bestimmen. So kann das Erlauben des Stoppens des Antriebsmotors vom Vorliegen eines Mindestladezustands der Fahrzeugbatterie abhängig gemacht werden. Die Differenz zwischen dem aktuellen Ladezustand und dem Grenzwert des Ladezustands gibt dann an, um wie viel die Fahrzeugbatterie während der Stopp-Phase entladen werden kann. Erlaubt diese Ladezustandsreserve eine Standzeit des Antriebsmotors für die Dauer einer vorgegebenen Zeitspanne, dann wird der Start-Stopp-Betrieb freigegeben.

Die vorgegebene Zeitspanne, während welcher der Antriebsmotor außer Betrieb genommen ist, ist vorzugsweise so gewählt, dass dem Fahrzeugnutzer das Stoppen des Antriebsmotors plausibel erscheint und gleichzeitig dennoch eine ausreichende Versorgung der Bordnetzverbraucher mit elektrischer Energie über die vorgegebene Zeitspanne hinweg sichergestellt ist.

Gemäß einem weiteren Aspekt der Erfindung ist eine weitere Möglichkeit der Verwendung des Mittelwerts in einer Steuereinrichtung für ein eine Fahrzeugbatterie aufweisendes Fahrzeug realisiert, welche eine Erfassungseinrichtung zum Erfassen eines Werts eines Spannungseinbruchs an der Fahrzeugbatterie beim Starten eines Antriebsmotors des Fahrzeugs umfasst, wobei die Steuereinrichtung zum Bilden eines Mittelwerts aus einer Mehrzahl an derartigen Werten des Spannungseinbruchs ausgelegt ist. Hierbei umfasst die Steuereinrichtung eine Auswerteeinrichtung, die dazu ausgelegt ist, den Mittelwert dazu heranzuziehen, eine beim nächsten Starten des Antriebsmotors zu erwartende Spannung an der Fahrzeugbatterie vorherzusagen.

Die Steuereinrichtung weist die zur Durchführung des erfindungsgemäßen Verfahrens vorzusehenden Einrichtungen auf, und die für das erfindungsgemäße Verfahren beschriebenen Vorteile und bevorzugten Ausführungsformen gelten auch für die erfindungsgemäße Steuereinrichtung.

Die vorstehend in der Beschreibung genannten Merkmale und Merkmalskombinationen sowie die nachfolgend in der Figurenbeschreibung genannten und/oder in der Figur alleine gezeigten Merkmale und Merkmalskombinationen sind nicht nur in der jeweils angegebenen Kombination, sondern auch in anderen Kombinationen oder in Alleinstellung verwendbar, ohne den Rahmen der Erfindung zu verlassen.

Weitere Vorteile, Merkmale und Einzelheiten der Erfindung ergeben sich aus den Ansprüchen, der nachfolgenden Beschreibung einer bevorzugten Ausführungsform sowie anhand der Zeichnung.

Diese zeigt in zwei Diagrammen schematisch den Verlauf von Spannung und Strom im Bordnetz eines Fahrzeugs im Start-Stopp-Betrieb.

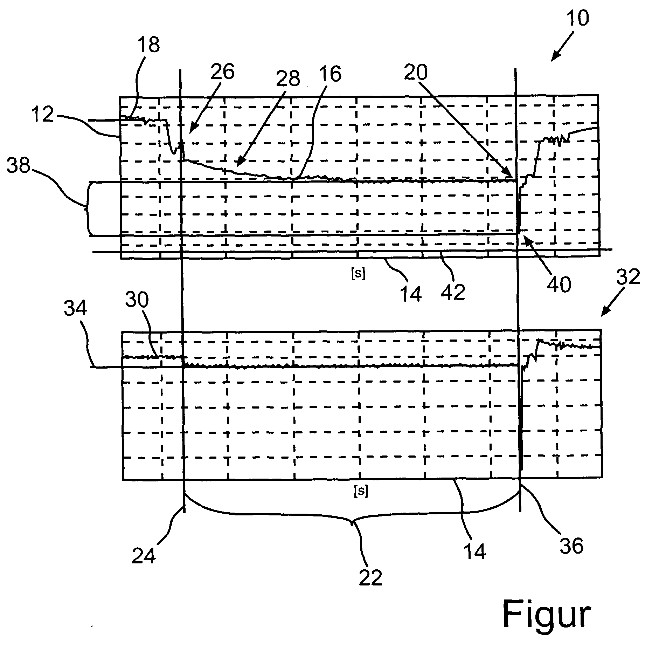

In einem ersten Diagramm 10 der Figur ist auf einer Ordinate 12 die an der Fahrzeugbatterie anliegende Spannung auftragen. Die Abszisse des Diagramms 10 ist die Zeitachse 14 . Eine Kurve 16 veranschaulicht den Verlauf der Spannung während des Start-Stopp-Betriebs des Fahrzeugs.

Während der Antriebsmotor des Fahrzeugs läuft und einen Generator antreibt, befindet sich die Spannung auf einem Ausgangsniveau 18 . Dieses Ausgangsniveau 18 wird hauptsächlich durch die Generatorauslastung und die Generatorsteuerung bestimmt. Ein Spannungsniveau 20 am Ende einer Stopp-Phase 22 des Antriebsmotors ist hingegen durch den Ladezustand, die Größe und die Temperatur der Fahrzeugbatterie sowie den Bordnetzlaststrom bestimmt.

Mit Beginn 24 der Stopp-Phase 22 zeigt die Kurve 16 zunächst einen steilen Abfall 26 , und anschließend ein dem Verlauf einer Exponentialfunktion ähnelndes Abnehmen 28. Der steile Abfall 26 resultiert daraus, dass der Generator nach dem Stoppen des Antriebsmotors keine Energie mehr in das Bordnetz einspeist. Das expotentielle Abnehmen 28 spiegelt den Abbau von Überspannung an der Fahrzeugbatterie wieder, welche aus der vorhergehenden Ladephase herrührt. Der Verlauf der Kurve 16 während der Stopp-Phase 22 ist abhängig von der Ladedauer und der Höhe des Ladestroms 30, welcher, wie in einem zweiten Diagramm 32 erkennbar ist, ebenfalls mit dem Beginn 24 der Stopp-Phase 22 von einem Ausgangsniveau ausgehend sich auf ein zweites Niveau 34 verändert, bei welchem es sich dann um einen Entladestrom handelt.

Dauert die Stopp-Phase 22 über eine längere Zeitspanne hinweg an, etwa über die vorliegend beispielhaft gezeigte Zeitspanne von zwei Minuten, so ist die Exponentialfunktion weitgehend eingeschwungen und stellt sich ein annähernd horizontaler, ein geringes Gefälle aufweisender Verlauf der Kurve 16 ein. Das geringe Gefälle wird durch ein Fortschreiten der Entladung der Fahrzeugbatterie auf Grund des Entladestroms im Bordnetz verursacht.

Am Ende 36 der Stopp-Phase 32 , also beim auf die Stopp-Phase 22 folgenden nächsten Starten des Antriebsmotors des Fahrzeugs erfolgt ein Spannungseinbruch 38 (vgl. Diagramm 10 ). Dieser Spannungseinbrauch 38 ist fahrzeugspezifisch und wird wie nachfolgend beschrieben adaptiv eingelernt. Um den fahrzeugspezifischen Spannungseinbruch 38 zu ermitteln, wird aus einer Mehrzahl von Werten eines jeweils beim Starten nach der Stopp-Phase 22 sich einstellenden Spannungseinbruchs 38 ein Mittelwert gebildet. Beispielsweise kann der Mittelwert aus den acht letzten Werten des Spannungseinbruchs 38 gebildet sein.

Bevorzugt wird der Wert des Spannungseinbruchs 38 nur dann zum Bilden des Mittelwerts herangezogen, wenn die Kühlmitteltemperatur des Antriebsmotors größer als beispielsweise 20°C ist. Damit wird sichergestellt, dass beim Bilden des Mittelwerts aus den einzelnen Werten des Spannungseinbruchs 38 nur Warmstarts berücksichtigt werden. Bevorzugt ist des Weiteren die Spannung an der Fahrzeugbatterie vor dem Starten kleiner als ein vorgegebener Mindestwert, beispielsweise kleiner als 12,8 V. Damit kann sichergestellt werden, dass Überspannung an der Fahrzeugbatterie schon weit genug abgebaut ist. Des Weiteren beträgt der Ladezustand der Fahrzeugbatterie bevorzugt mehr als 55%, wenn der Wert des Spannungseinbruchs 38 zum Bilden des Mittelwerts herangezogen werden soll. Ab einem Ladezustand der Fahrzeugbatterie von mindestens 55% ist nämlich der Spannungseinbruch 38 weitgehend unabhängig vom Ladezustand.

Des Weiteren wird der Mittelwert auf einen Bezugswert der Batterietemperatur bezogen, beispielsweise auf einen Wert von 20°C. Diese Normierung des Mittelwerts kann bei Temperaturen von weniger als 20°C über eine lineare Abhängigkeit des Spannungseinbruchs 38 von der Temperatur der Fahrzeugbatterie vorgenommen werden. Hierbei kann etwa davon ausgegangen werden, dass der Spannungseinbruch 38 pro °C geringere Temperatur als 20°C um 24 mV zunimmt. Bei einer Temperatur von mehr als 20°C ist der Spannungseinbruch 38 hingegen weitgehend unabhängig von der Batterietemperatur.

Eine zu erwartende Spannung 40 nach dem Ende 36 der Stopp-Phase 22, nämlich beim Starten des Antriebsmotors, wird unter Heranziehung des Mittelwerts des Spannungseinbruchs 38 , welcher auf die aktuelle Batterietemperatur entnormiert ist, bestimmt. Die zu erwartende Spannung 40 ergibt sich aus dem Spannungsniveau 20 zum Ende 36 der Stopp-Phase 22 , jedoch vor dem Starten des Antriebsmotors, abzüglich des auf die aktuelle Batterietemperatur entnormierten Mittelwerts des Spannungseinbruchs 38 . Beim Vorhersagen der beim Starten des Antriebsmotors zu erwartenden Spannung 40 an der Fahrzeugbatterie wird also die Temperatur der Fahrzeugbatterie berücksichtigt.

Der Abstand zwischen der zu erwartenden Spannung 40 und einer Mindestspannung 42, welche beim Starten des Antriebsmotors den Bordnetzverbrauchern, insbesondere Steuergeräten, zur Verfügung stehen soll, stellt also die Reserve da, welche durch den Bordstrom während der Stopp-Phase 22 entladen werden darf.

Ist aus den letzten acht Werten der Spannungseinbrüche 38 der Mittelwert gebildet, wird periodisch ein minimales Spannungsniveau am Ende der Stopp-Phase 22 bestimmt, indem zu der Mindestspannung 42 der Mittelwert der letzten acht Spannungseinbrüche 38 hinzuaddiert wird. Liegt die am Ende der Stopp-Phase 22 zu erwartende Spannung 20 über diesem minimalen Spannungsniveau, so kann das Fahrzeug im Start-Stopp-Betrieb betrieben werden.

Das minimale Spannungsniveau, welches trotz des Spannungseinbruchs 38 dazu führt, dass eine zu erwartende Spannung beim auf die Stopp-Phase 22 folgenden nächsten Starten des Antriebsmotors oberhalb der für die Bordnetzverbraucher vorzusehenden Mindestspannung 42 liegt, korreliert mit einem Grenzwert des Ladezustands der Fahrzeugbatterie. Liegt dieser Grenzwert des Ladezustands der Fahrzeugbatterie vor, wird ein Stoppen des Antriebsmotors erlaubt. Liegt der aktuelle Ladezustand der Fahrzeugbatterie oberhalb dieses Grenzwerts des Ladezustands, so ist durch die Differenz die Ladung angegeben, welche während der Stopp-Phase 22 maximal entladen werden darf. Ist hierbei eine Stopp-Phase 22 von der vorgegebenen Dauer - also etwa von den beispielhaft angegebenen zwei Minuten - möglich, dann wird der Start-Stopp-Betrieb des Fahrzeugs freigegeben.

## Patentansprüche

1. Verfahren zum Betreiben eines Fahrzeugs mit einer Fahrzeugbatterie, bei welchem beim Starten eines Antriebsmotors des Fahrzeugs der Wert eines Spannungseinbruchs (38) an der Fahrzeugbatterie erfasst wird, und bei welchem ein Mittelwert gebildet wird,
**dadurch gekennzeichnet, dass**
der Mittelwert aus einer Mehrzahl an derartigen Werten des Spannungseinbruchs (38) gebildet wird, wobei jeweils ein Wert der Mehrzahl an derartigen Werten bei jeweils einem Starten des Antriebsmotors erfasst wird, und der Mittelwert dazu herangezogen wird, eine beim nächsten Starten des Antriebsmotors zu erwartende Spannung (40) an der Fahrzeugbatterie vorherzusagen, wobei der Mittelwert auf einen Bezugswert einer Batterietemperatur der Fahrzeugbatterie normiert wird und wobei die zu erwartende Spannung (40) aus einem Spannungsniveau (20) an einem Ende einer Stopp-Phase (22) eines Start-Stopp-Betriebs des Fahrzeugs vor dem nächsten Starten des Antriebsmotors abzüglich des auf eine aktuelle Batterietemperatur der Fahrzeugbatterie entnormierten Mittelwerts der Werte des Spannungseinbruchs (38) berechnet wird.

2. Verfahren nach Anspruch 1,
**dadurch gekennzeichnet, dass**
ein dem nächsten Starten vorausgehendes Stoppen des Antriebsmotors unterbunden wird, wenn die zu erwartende Spannung (40) an der Fahrzeugbatterie geringer ist als eine vorgegebene Mindestspannung (42).

3. Verfahren nach Anspruch 1 oder 2,
**dadurch gekennzeichnet, dass**
aus der Summe des Mittelwerts und einer vorgegebenen Mindestspannung (42) ein, insbesondere zum Bestimmen eines Grenzwerts eines Ladezustands der Fahrzeugbatterie herangezogener, Grenzwert der Spannung bestimmt wird, bei dessen Überschreiten ein Stoppen des Antriebsmotors, insbesondere während einer vorgegebenen Zeitspanne, erlaubt wird.

4. Verfahren nach einem der Ansprüche 1 bis 3,
**dadurch gekennzeichnet, dass**
aus den Werten des Spannungseinbruchs (38) der Mittelwert gebildet wird, wenn
- ein Wert der Kühlmitteltemperatur des Antriebsmotors und/oder
- ein Wert der Spannung an der Fahrzeugbatterie vor dem Starten und/oder
- ein Wert eines Ladezustands der Fahrzeugbatterie größer ist als ein vorgegebener Mindestwert.

5. Steuereinrichtung für ein Fahrzeug mit einer Fahrzeugbatterie, mit einer Erfassungseinrichtung zum Erfassen eines Spannungseinbruchs (38) an der Fahrzeugbatterie als Wert beim Starten eines Antriebsmotors des Fahrzeugs, wobei die Steuereinrichtung zum Bilden eines Mittelwerts ausgelegt ist,
**dadurch gekennzeichnet, dass**
die Steuereinrichtung zum Bilden des Mittelwerts aus einer Mehrzahl an derartigen Werten des Spannungseinbruchs (38) ausgebildet ist, wobei der Mittelwert auf einen Bezugswert einer Batterietemperatur der Fahrzeugbatterie normiert wird, wobei mittels der Erfassungseinrichtung jeweils ein Wert der Mehrzahl an derartigen Werten bei jeweils einem Starten des Antriebsmotors erfassbar ist, und die Steuereinrichtung eine Auswerteeinrichtung umfasst, welche dazu ausgelegt ist, den Mittelwert dazu heranzuziehen, eine beim nächsten Starten des Antriebsmotors zu erwartende Spannung (40) an der Fahrzeugbatterie vorherzusagen, wobei die zu erwartende Spannung (40) aus einem Spannungsniveau (20) an einem Ende einer Stopp-Phase (22) eines Start-Stopp-Betriebs des Fahrzeugs vor dem Starten des Antriebsmotors abzüglich des auf eine aktuelle Batterietemperatur der Fahrzeugbatterie entnormierten Mittelwerts der Werte des Spannungseinbruchs (38) berechnet wird.

6. Steuereinrichtung nach Anspruch 5,
**dadurch gekennzeichnet, dass**
die Steuereinrichtung zum Durchführen eines Verfahrens nach einem der Ansprüche 1 bis 6 ausgebildet ist.

## Claims

1. A method for operating a vehicle having a vehicle battery, the method comprising, on starting of a drive motor of the vehicle, detecting a value of a voltage drop (38) at the vehicle battery, and calculating a mean value,
**characterized by**
calculating the mean value from a plurality of such values of the voltage drop (38), wherein one value of the plurality of such values is detected for a respective one starting process of the drive motor, and taking into account the mean value to predict an expected voltage (40) at the vehicle battery for the next starting process of the drive motor, wherein the mean value is normalised to a reference value of a battery temperature of the vehicle battery and the expected voltage (40) is calculated from a voltage level (20) at the end of a stop phase (22) of a start-stop operation of the vehicle before the next starting process of the drive motor after subtraction of the mean value of the values of the voltage drop (38), the mean value being de-normalised to an actual battery temperature of the vehicle battery.

2. The method according to claim 1,
**characterized by**
preventing a stopping of the drive motor preceding the next starting of the drive motor if the expected voltage (40) at the vehicle battery is lower than a specified minimum voltage (42).

3. The method according to claim 1 or 2,
**characterized by**
calculating a threshold value of the voltage from the sum of the mean value and a specified minimum voltage (42), the threshold value being in particular taken into account for determining a threshold value of a charge level of the vehicle battery, wherein a stopping of the drive motor, in particular during a predetermined time period, is enabled when the threshold value of the voltage is exceeded.

4. The method according to any of claims 1 to 3,
**characterized by**
calculating the mean value from the values of the voltage drop (38) if
- a value of the coolant temperature of the drive motor and/or
- a value of the voltage at the vehicle battery before starting and/or
- a value of a charge level of the vehicle battery
exceeds a predetermined minimum value.

5. A control device for a vehicle having a vehicle battery, comprising a detection unit for detecting a value of a voltage drop (38) at the vehicle battery on starting of a drive motor of the vehicle, wherein the control device is configured to calculate a mean value,
**characterized in that**
the control device is configured to calculate the mean value from a plurality of such values of the voltage drop (38), wherein the mean value is normalised to a reference value of a battery temperature of the vehicle battery, wherein one value of the plurality of such values is detected by the detection unit for a respective one starting process of the drive motor, and the control unit comprises an evaluation unit configured to take into account the mean value to predict an expected voltage (40) at the vehicle battery for a next starting of the drive motor, wherein the expected voltage (40) is calculated from a voltage level (20) at the end of a stop phase (22) of a start-stop operation of the vehicle before the next starting of the drive motor after subtraction of the mean value of the values of the voltage drop (38), the mean value being de-normalised to an actual battery temperature of the vehicle battery.

6. The control device according to claim 5,
**characterized in that**
the control device is configured to perform a method according to any of claims 1 to 6.

## Revendications

1. Procédé permettant de faire fonctionner un véhicule avec une batterie de véhicule, dans lequel, au démarrage d'un moteur de commande du véhicule, la valeur d'une chute de tension (38) est détectée sur la batterie du véhicule et dans lequel est formée une valeur moyenne,
**caractérisé en ce que** :
la valeur moyenne est formée d'une pluralité de ces valeurs de la chute de tension (38), dans lequel, respectivement, une valeur de la pluralité de ces valeurs est détectée respectivement lors d'un démarrage du moteur de commande et la valeur moyenne est mise à contribution pour prédire une tension (40) à escompter lors du prochain démarrage du moteur de commande sur la batterie du véhicule, dans lequel la valeur moyenne est normalisée à une valeur de référence d'une température de la batterie du véhicule et dans lequel la tension à escompter (40) est calculée à partir d'un niveau de tension (20) à la fin d'une phase d'arrêt (22) d'une commande de démarrage-arrêt du véhicule avant le prochain démarrage du moteur de commande moins la valeur moyenne des valeurs de la chute de tension (38) dénormalisée à une température courante de la batterie du véhicule.

2. Procédé selon la revendication 1,
**caractérisé en ce que** :
un arrêt du moteur de commande précédant le prochain démarrage est supprimé si la tension à escompter (40) sur la batterie du véhicule est plus faible qu'une tension minimale préétablie (42).

3. Procédé selon la revendication 1 ou 2,
**caractérisé en ce que** :
à partir de la somme de la valeur moyenne et d'une tension minimale préétablie (42), on détermine une valeur limite de la tension mise à contribution en particulier pour déterminer une valeur limite d'un état de charge de la batterie du véhicule, tension dont le dépassement permet un arrêt du moteur de commande, en particulier au cours d'un intervalle de temps préétabli.

4. Procédé selon l'une quelconque des revendications 1 à 3,
**caractérisé en ce que** :
on forme la valeur moyenne à partir des valeurs de la chute de tension (38) si :
- une valeur de la température du réfrigérant du moteur de commande et/ou
- une valeur de la tension sur la batterie du véhicule avant le démarrage et/ou
- une valeur d'un état de charge de la batterie du véhicule
est ou sont plus grandes qu'une valeur minimale préétablie.

5. Dispositif de commande pour un véhicule pourvu d'une batterie de véhicule, d'un dispositif de détection permettant de détecter une chute de la tension (38) sur la batterie du véhicule comme valeur au démarrage d'un moteur de commande du véhicule, dans lequel le dispositif de commande est conçu pour former une valeur moyenne,
**caractérisé en ce que** :
le dispositif de commande est conçu pour former la valeur moyenne à partir d'une pluralité de ces valeurs de la chute de tension (38), dans lequel la valeur moyenne est normalisée à une valeur de référence d'une température de la batterie du véhicule, dans lequel, au moyen du dispositif de détection, on peut détecter respectivement une valeur de la pluralité de ces valeurs respectivement lors d'un démarrage du moteur de commande et le dispositif de commande comprend un dispositif d'évaluation qui est conçu pour mettre à contribution la valeur moyenne afin de prédire une tension (40) à escompter lors du prochain démarrage du moteur de commande sur la batterie du véhicule, dans lequel la tension à escompter (40) est calculée à partir d'un niveau de tension (20) à la fin d'une phase d'arrêt (22) d'une commande de démarrage-arrêt du véhicule avant le démarrage du moteur de commande moins la valeur moyenne des valeurs de la chute de tension (38) dénormalisée à une température courante de la batterie du véhicule.

6. Dispositif de commande selon la revendication 5,
**caractérisé en ce que** :
le dispositif de commande est conçu pour réaliser un procédé selon l'une quelconque des revendications 1 à 6.
